(19) Europäisches Patentamt
European Patent Office
Office européen des brevets

(11) **EP 2 613 330 A1**

(12) **EUROPEAN PATENT APPLICATION**

(43) Date of publication:
**10.07.2013 Bulletin 2013/28**

(51) Int Cl.:
*H01G 9/20* (2006.01)

(21) Application number: **12193976.3**

(22) Date of filing: **23.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.01.2012 KR 20120002460**

(71) Applicant: **Samsung SDI Co., Ltd.**
**Yongin-si, Gyeonggi-do (KR)**

(72) Inventors:
• **Shin, Byong-Cheol**
**Gyeonggi-do (KR)**
• **Lee, Ji-Won**
**Gyeonggi-do (KR)**
• **Park, Do-Young**
**Gyeonggi-do (KR)**

(74) Representative: **Taor, Simon Edward William et al**
**Venner Shipley LLP**
**200 Aldersgate**
**London EC1A 4HD (GB)**

(54) **Dye sensitized solar cell**

(57) A dye sensitized solar cell including: a first electrode; a photoelectrode on a surface of the first electrode and including titanium dioxide nanoparticles; a second electrode facing the first electrode; and an electrolyte between the first electrode and the second electrode. An aspect ratio of the titanium dioxide nanoparticles is from about 3 to about 5.

**FIG. 1**

**Description**

Aspects of embodiments of the present invention relate to a dye sensitized solar cell.

A dye sensitized solar cell includes a negative photoelectrode to which a photosensitive dye is adsorbed, an electrolyte containing oxidation/reduction ion pairs, and a counter electrode including a platinum (Pt) catalyst. The negative photoelectrode includes metal oxide particles having a wide band gap.

In dye sensitized solar cells, when solar light is incident thereto, a photosensitive dye absorbs light and is excited, and then transfers electrons into a metal oxide conduction band. Then, the conducted electrons flow to an external circuit to transfer electric energy thereto, and then the electrons, whose energy is reduced by the amount of transferred energy, flow to a counter electrode.

Then, the photosensitive dye receives the same number of electrons as those emitted to the metal oxide from an electrolyte to return to a ground state. In this regard, the electrolyte transfers electrons from the counter electrode to the photosensitive dye through an oxidization and reduction reaction.

In order to increase energy conversion efficiency of a dye sensitized solar cell, the dye adsorption amount needs to be increased to increase photoelectron generation efficiency.

According to an aspect of embodiments of the present invention, a dye sensitized solar cell has improved efficiency.

Additional aspects and features of embodiments of the present invention are set forth in part in the description which follows and, in part, will be apparent from the description, or may be learned by practice of the presented embodiments.

According to one or more embodiments of the present invention, a dye sensitized solar cell includes: a first electrode; a photoelectrode on a surface of the first electrode and including titanium dioxide nanoparticles; a second electrode facing the first electrode; and an electrolyte between the first electrode and the second electrode. An aspect ratio of the titanium dioxide nanoparticles is from about 3 to about 5.

The aspect ratio of the titanium dioxide nanoparticles may be from about 3.5 to about 4.5.

A specific surface area of the titanium dioxide nanoparticles may be 80 $m^2$/g or greater. A specific surface area of the titanium dioxide nanoparticles may be from about 81 to about 90 $m^2$/g.

A pore volume of the titanium dioxide nanoparticles may be 0.30 $cm^3$/g or greater. A pore volume of the titanium dioxide nanoparticles may be from about 0.30 to about 0.33 $cm^3$/g.

A pore size of the titanium dioxide nanoparticles may be 14 nm or greater. A pore size of the titanium dioxide nanoparticles may be from about 14 to about 16 nm.

An average diameter of the titanium dioxide nanoparticles may be from about 10 to about 90 nm. An average diameter of the titanium dioxide nanoparticles may be from about 15 to about 25 nm.

The photoelectrode may further include a dye including at least one selected from the group consisting of aluminum (Al), platinum (Pt), palladium (Pd), europium (Eu), lead (Pb), iridium (Ir), and ruthenium (Ru).

According to an aspect of the invention, there is provided a dye sensitized solar cell as set out in claim 1. Preferred features of this aspect are set out in claims 2 to 12.

The accompanying drawings, together with the specification, illustrate some exemplary embodiments of the present invention, and, together with the description, serve to explain aspects and principles of the present invention.

FIG. 1 is a cross-sectional view of a dye sensitized solar cell according to an embodiment of the present invention;
FIG. 2A is a transmission electron microscopy (TEM) image of titanium dioxide nanoparticles used in an example according to an embodiment of the present invention; and
FIG. 2B is a TEM image of titanium dioxide nanoparticles used in a comparative example.

The present invention is described more fully hereinafter with reference to the accompanying drawings, in which some exemplary embodiments of the invention are shown and described. However, as those skilled in the art would realize, the described embodiments may be modified in various different ways, all without departing from the scope of the present invention. Accordingly, the drawings and description are to be regarded as illustrative in nature and not restrictive. Like reference numerals refer to like elements throughout.

Hereinafter, some exemplary embodiments of a dye sensitized solar cell and a method of manufacturing the same according to the present invention are described in further detail.

A dye sensitized solar cell according to an embodiment of the present invention includes: a first electrode; a photoelectrode that is disposed on a surface of the first electrode and includes titanium dioxide nanoparticles; a second electrode that is disposed facing the first electrode on which the photoelectrode is disposed; and an electrolyte interposed between the first electrode and the second electrode, wherein an aspect ratio of the titanium dioxide nanoparticles is in a range of from 3 to 5. In one embodiment, an aspect ratio of the titanium dioxide nanoparticles may be in a range of from 3.5 to 4.5. When the aspect ratio of the titanium dioxide nanoparticles is too great, a specific surface area may be reduced and, thus, a dye adsorption amount may be reduced. When the aspect ratio of the titanium dioxide nanoparticles is too small, electron delivery activity may be degraded.

In one embodiment, the dye sensitized solar cell includes a long rod-shaped titanium dioxide having a limited aspect ratio, and due to the inclusion of the long rod-shaped titanium dioxide, the dye sensitized solar cell has a high dye adsorption amount and, as a result, provides improved photoelectric conversion efficiency.

In one embodiment, a specific surface area of the titanium dioxide nanoparticles included in the dye sensitized solar cell measured by a Brunauer-Emmett-Teller (BET) measurement method may be 80 $m^2$/g or greater. In one embodiment, a specific surface area of the titanium dioxide nanoparticles may be in a range of from about 81 $m^2$/g to about 90 $m^2$/g. When the aspect ratio of the titanium dioxide nanoparticles is too great, the decrease in the specific surface area may result in a decrease in the dye adsorption amount. On the other hand, when the aspect ratio is too small, electron delivery activity may be degraded.

In one embodiment, a pore volume of the titanium dioxide nanoparticles included in the dye sensitized solar cell may be 0.30 $cm^3$/g or greater. In one embodiment, a pore volume of the titanium dioxide nanoparticles may be in a range of from about 0.30 $cm^3$/g to about 0.33 $cm^3$/g. When the pore volume of the titanium dioxide nanoparticles is too great, inter-particle linking may be difficult, and on the other hand, when the pore volume of the titanium dioxide nanoparticles is too small, nanoparticles may agglomerate.

In one embodiment, a pore size of the titanium dioxide nanoparticles included in the dye sensitized solar cell may be 14 nm or greater. In one embodiment, a pore size of the titanium dioxide nanoparticles may be in a range of from about 14 nm to about 16 nm. When the pore size of the titanium dioxide nanoparticles is too great, inter-particle linking may be difficult, and on the other hand, when the pore size of the titanium dioxide nanoparticles is too small, the electrolyte may not easily permeate into pores of the nanoparticles. In this regard, the pore size refers to a pore diameter.

In one embodiment, an average diameter of the titanium dioxide nanoparticles included in the dye sensitized solar cell may be in a range of from about 10 to about 90 nm. In one embodiment, an average diameter of the titanium dioxide nanoparticles may be in a range of from about 15 to about 90 nm. In one embodiment, an average diameter of the titanium dioxide nanoparticles may be in a range of from about 15 to about 25 nm. When the average diameter of the titanium dioxide nanoparticles is too great, a decrease in the specific surface area may result, thereby inducing a decrease in the dye absorption amount, and on the other hand, when the average diameter of the titanium dioxide nanoparticles is too small, electron delivery activity may be degraded. In other embodiments, the average diameter of the titanium dioxide nanoparticles may be from about 15 to about 90 nm or from about 10 to about 25nm.

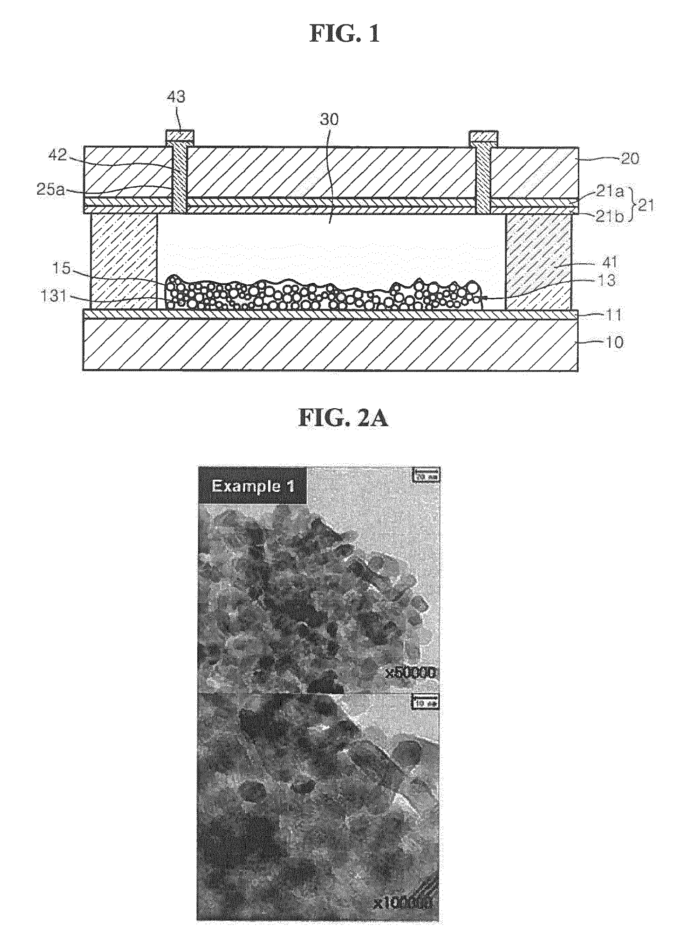

FIG. 1 is a cross-sectional view of a dye sensitized solar cell according to an embodiment of the present invention.

Referring to FIG. 1, the dye sensitized solar cell according to an embodiment of the present invention includes a first substrate 10 on which a first electrode 11 and a dye sensitized negative photoelectrode 13 containing a dye 15 are disposed; a second substrate 20 on which a second electrode 21 is disposed; and an electrolyte 30 disposed between the first electrode 11 and the second electrode 21, wherein the first substrate 10 and the second substrate 20 face each other. A case (not shown) may be disposed to envelop the first substrate 10 and the second substrate 20. The structure of the dye sensitized solar cell according to an embodiment of the present invention is described in further detail below.

The first substrate 10, which supports the first electrode 11, is transparent and thus light is transmitted therethrough. In one embodiment, the first substrate 10 may be formed of glass or a plastic. Examples of the plastic include polyethylene terephthalate (PET), polyethylene naphthalate (PEN), polycarbonate (PC), polypropylene (PP), polyimide (PI), and triacetyl cellulose (TAC). Other embodiments of the invention may use other materials for the substrate. The first substrate 10 may have a visible ray transmittance of 91% or greater, and a total amount of iron, which is calculated based on $Fe_2O_3$, may be 150 ppm or less. The thickness of the first substrate 10 may be in a range of from about 1 to about 5 mm.

The first electrode 11 disposed on the first substrate 10 may consist of an indium tin oxide, an indium oxide, a tin oxide, a zinc oxide, a sulfur oxide, a fluorine oxide, a mixture thereof, $ZnO$-$Ga_2O_3$, or $ZnO$-$AlO_3$.). Other embodiments of the invention may use other materials for the first electrode 11. The first electrode 11 may have a single or multi-layer structure including the transparent material.

The dye sensitized negative photoelectrode 13 is disposed on the first electrode 11. The dye sensitized negative photoelectrode 13 includes a plurality of titanium dioxide nanoparticles 131 having the aspect ratio of from about 3 to about 5. The dye sensitized negative photoelectrode 13 may have a thickness of from about 5000 nm to about 20,000 nm. However, embodiments of the present invention are not limited thereto, and the thickness of the dye sensitized negative photoelectrode 13 may be varied according to use or technology development.

In one embodiment, the dye sensitized negative photoelectrode 13 may be prepared as follows.

In one embodiment, titanium dioxide nanoparticles 131 (oxide semiconductor particles) as described above, an acid, a binder, and a solvent are mixed to form a composition for forming an oxide semiconductor layer (photoelectrode).

The composition may have a viscosity of from about 10,000 to about 30,000 mPas and may be in a paste state. Examples of suitable acids are a hydrochloric acid, a nitric acid, an acetic acid, or the like, and an amount thereof may be in a range of from about 50 to about 300 parts by weight based on 100 parts by weight of the titanium dioxide nanoparticles 131. When the amount of the acid is within the range described above, the photoelectrode 13 manufactured using an oxide semiconductor layer formed from the acid may have desired photoelectric characteristics.

As the binder, materials such as ethylcellulose or hydropropylcellulose or the like may be used, and an amount thereof may be in a range of from about 5 to about 50 parts by weight based on 100 parts by weight of the titanium dioxide nanoparticles 131. When the amount of the binder is within the range described above, the photoelectrode 13 manufactured using an oxide semiconductor layer including the acid may have desired photoelectric characteristics.

As the solvent, solvents such as terpineol, ethanol, distilled water, ethylene glycol, alpha-terpineol, or the like may be used, and an amount thereof may be in a range of from about 200 to about 900 parts by weight based on 100 parts by weight of the titanium dioxide nanoparticles 131. When the amount of the solvent is within the range described above, the photoelectrode 13 manufactured using an oxide semiconductor layer formed from the acid may have desired photoelectric characteristics.

In one embodiment, the composition is coated on a substrate, that is, the first electrode 11 of the first substrate 10, and then heat treated at a temperature of from about 400 to about 550 °C to form an oxide semiconductor layer.

As a method of coating the composition on a substrate, spin coating, dip coating, casting, screen printing, or the like may be used, and a thickness of the oxide semiconductor layer may be in a range of from about 1000 to about 20,000 nm. The coating and the heat treating may be repeatedly performed several times.

A dye 15 which absorbs light and generates excited electrons is adsorbed to surfaces of the dye sensitized negative photoelectrode 13.

The dye 15 may include at least one selected from the group consisting of aluminum (Al), platinum (Pt), palladium (Pd), europium (Eu), lead (Pb), iridium (Ir), and ruthenium (Ru). In one embodiment, the dye 15 may be a ruthenium dye, but embodiments of the invention are not limited thereto, and the dye 15 may be any suitable dye that is sensitive to solar light.

For example, the dye 15 may be an organic dye that has an excellent molar extinction coefficient and high photoelectric conversion efficiency in a visible light wavelength range. Further, for example, the dye 15 may be an inexpensive dye which may be used as a replacement for an expensive inorganic ruthenium dye.

For example, the dye 15 may be a ruthenium-based dye, $N_3$, $N_{719}$, Black dye, or the like. N3 refers to $RuL_2(NCS)_2$ (L=2,2'-bibyridyl-4,4'-dicarboxylic acid), N719 refers to $RuL_2(NCS)_2$]:2TBA (where L=2,2'-bipyridyl-4,4'-dicarboxylic acid, and TBA=tetra-n-butylammonium).

In one embodiment, a 0.1 to 7 mM dye solution is prepared and then the photoelectrode 13 is immersed therein to adsorb the dye 15 thereto. In this regard, the choice of dye concentration need not lie in the above range, as long as the desired dye adsorption is possible. A solvent that is available herein may be ethanol, isopropanol, acetonitrile, valeronitrile, or the like, but the present invention is not limited thereto. For example, any suitable solvent may be used as the solvent.

The second substrate 20 disposed to face the first substrate 10 may function as a supporter for the second electrode 21, and may be transparent. The second substrate 20, like the first substrate 10, may also be formed of glass or a plastic.

The second electrode 21 disposed on the second substrate 20 is disposed to face the first electrode 11, and, in one embodiment, may include a transparent electrode 21a and a catalyst electrode 21b. In one embodiment, the transparent electrode 21a may have a thickness of from about 100 to about 1000 nm. In one embodiment, the catalyst electrode 21b may have a thickness of from about 1 to about 100 nm.

The transparent electrode 21a may be formed of a transparent material, such as an indium tin oxide, a fluoro tin oxide, an antimony tin oxide, a zinc oxide, a tin oxide, $ZnO-Ga_2O_3$, $ZnO-Al_2O_3$, or the like. The transparent electrode 21a may have a single or multi-layer structure including the transparent material. The catalyst electrode 21b activates a redox couple, and may be formed of platinum (Pt), ruthenium (Ru), palladium (Pd), iridium (Ir), rhodium (Rh), osmium (Os), carbon (C), $WO_3$, $TiO_2$, or the like.

The first substrate 10, in one embodiment, is coupled to the second substrate 20 via an adhesive 41. The electrolyte 30 may be injected into a space between the first electrode 11 and the second electrode 21 through a hole 25a penetrating the second substrate 20 and the second electrode 21 such that the first and second electrodes 11 and 21 are impregnated with the electrolyte 30. The electrolyte 30 may be uniformly dispersed in the dye sensitized negative photoelectrode 13. The electrolyte 30 transfers electrons from the second electrode 21 to the dye 15 through oxidation and reduction. The hole 25a penetrating the second substrate 20 and the second electrode 21 may be sealed using an adhesive 42 and a cover glass 43.

In one embodiment, the electrolyte 30 may be 0.6M 1,2-dimethyl-3-hexylimidazolium iodide, 0.5M 4-tertbutylpyrimidine, 0.1M LiI and 0.05M $I_2$ dissolved in an acetonitrile solvent. Other embodiments of the invention may use other electrolytes.

Although not illustrated in FIG. 1, a porous metal oxide film may further be formed on an upper surface of the first electrode 11 and a lower surface of the dye sensitized negative photoelectrode 13.

The porous metal oxide film may be formed of metal oxide particles including a titanium oxide, a zinc oxide, a tin oxide, a strontium oxide, an indium oxide, an iridium oxide, a lanthanum oxide, a vanadium oxide, a molybdenum oxide, a tungsten oxide, a niobium oxide, a magnesium oxide, an aluminum oxide, a yttrium oxide, a scandium oxide, a samarium oxide, a gallium oxide, a strontium titanium oxide, or the like. In this regard, according to an embodiment of the present invention, the metal oxide particles may be formed of $TiO_2$, $SnO_2$, $WO_3$, ZnO, or a complex thereof.

Hereinafter, one or more embodiments of the present invention are described in further detail with reference to the following examples. However, these examples are not intended to limit the purpose and scope of the one or more embodiments of the present invention.

**(Preparation of dye sensitized solar cell)**

**Example 1:**

A titanium dioxide paste as a composition for forming an oxide semiconductor layer was sequentially coated, dried, coated, and dried on a conductive thin film formed of FTO (2.2T, T: glass thickness) as a first electrode, and then a heat treatment was performed thereon at the temperature of 500 °C for about 30 minutes to form an oxide semiconductor layer having a thickness of 10 $\mu$m.

The titanium dioxide paste was prepared using rod-type titanium dioxide nanoparticles having an aspect ratio of from 3 to 5, a specific surface area of $85\pm5$ m$^2$/g, a pore volume of 0.32 cm$^3$/g, a pore size or 15.1 nm, and an average particle size of 20 nm. FIG. 2A shows a TEM image of the rod-type titanium dioxide nanoparticles. The rod-type titanium dioxide was obtained from Millennium Inorganic Chemicals, MIC, France.

The titanium dioxide paste was prepared by mixing and filtering titanium dioxide nanoparticles, a nitric acid, ethanol, and a dispersing agent (ED151).

Subsequently, the result was maintained at the temperature of 80 °C and then a dye adsorption treatment was performed thereon for 12 hours or longer by immersing the result in a dye dispersed solution in which 0.3 mM N719 as a dye was dissolved in ethanol.

Thereafter, the dye-adsorbed oxide semiconductor layer was washed with ethanol and then dried at room temperature to complete the production of a first electrode on which a photoelectrode was formed.

Separately, as a second electrode, a second conductive film formed of Pt was deposited on a first conductive film formed of ITO by using a sputter method, and then punched by using a drill having a diameter of 0.75 mm to form a fine pore for injection of an electrolyte.

A support formed of a thermoplastic polymer film (Surlyn, DuPont, USA) having a thickness of 60 $\mu$m was placed between the first electrode with the porous film and the second electrode and then, the resultant structure was compressed at the temperature of 100 °C for 9 seconds. Through the fine pore formed in the second electrode, an acetonitrile electrolyte including LiI (0.5M) and I (0.05M) was injected thereinto and then the fine pore was sealed by using a cover glass and a thermoplastic polymer film.

**Comparative Example 1:**

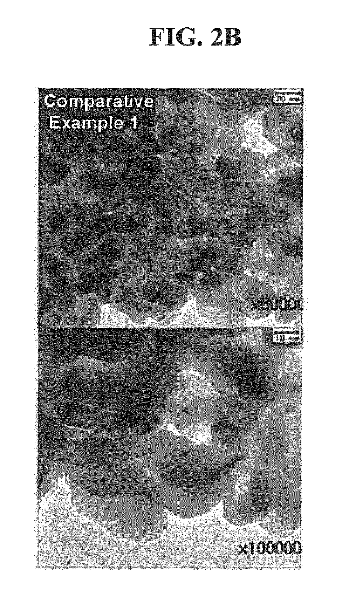

A dye sensitized solar cell was prepared in the same manner as in Example 1, except that oval titanium dioxide nanoparticles having an aspect ratio of 2, a specific surface area of $60\pm5$ m$^2$/g, a pore volume of 0.27 cm$^3$/g, a pore size of 12.71 nm, and an average particle size of 20 nm were used. FIG. 2B shows a TEM image of the oval titanium dioxide nanoparticles.

**Comparative Example 2:**

A dye sensitized solar cell was prepared in the same manner as in Example 1, except that titanium dioxide nanoparticles having an aspect ratio of 6, a specific surface area of $75\pm5$ m$^2$/g, a pore volume of 0.34 cm$^3$/g, a pore size of 17.5 nm, and an average particle size of $_{20}$ nm were used.

**Evaluation Example 1: Evaluation of incident-photon-to-current efficiency (IPCE)**

Photocurrent density of the dye sensitized solar cells prepared according to Example and Comparative Examples 1 and 2 was measured, and an open circuit voltage, current density, and fill factor were calculated from the photocurrent curve. The results are shown in Table 1 below, and energy conversion efficiencies of the dye sensitized solar cells were evaluated.

In this regard, a xenon (Xe) lamp was used as the light source, and the solar condition of the xenon lamp was adjusted using Fraunhofer Institute Solare Energiesysteme, Certificate No C-ISE369, Type of material, Mono-Si+KG filter, and the photocurrent density was measured at a power density of 100 mW/cm$^2$.

The conditions for measuring the open circuit voltage, photocurrent density, energy conversion efficiency, fill factor, and the amount of dye adsorbed, as shown in Table 1 below, were as follows.

(1) Open circuit voltage (V) and photocurrent density (mA/cm$^2$):

Open circuit voltage (V) and photocurrent density (mA/cm$^2$) were measured using a Keithley SMU$_{2400}$ apparatus.

(2) Energy conversion efficiency (%) and fill factor (%):

Energy conversion efficiency (%) was measured using 1.5 AM 100 mW/cm$^2$ solar simulator (Xe lamp [300W, Oriel], AM1.5 filter, and
Keithley SMU2400), and the fill factor was calculated using the energy conversion efficiency according to the following equation.

$$\text{Fill factor (FF) (\%)} = \{(J \times V)_{max} / (J_{sc} \times V_{oc})\} \times 100$$

In the equation, J is a value of the y-axis, V is a value of the x-axis, and Jsc and Voc are respectively the y-intercept and x-intercept of the J-V curve, i.e. energy conversion efficiency curve.

In addition, current-voltage characteristics of the dye sensitized solar cells were analyzed using a Xe lamp (100 mW/cm$^2$) as a light source.

Table 1

| | Current density (Jsc) [mAcm$^{-2}$] | Open circuit voltage (Voc) [V] | Fill factor (FF) [%] | Efficiency η [%] |
|---|---|---|---|---|
| Example 1 | 11.23 | 0.76 | 76 | 6.4 |
| Comparative Example 1 | 10.83 | 0.75 | 76 | 6.2 |
| Comparative Example 2 | 11.60 | 0.73 | 73 | 6.2 |

As shown in Table 1, the dye sensitized solar cell manufactured according to Example 1 showed higher efficiency than the dye sensitized solar cells manufactured according to Comparative Examples 1 and 2.

As described above, the dye sensitized solar cells according to one or more embodiments of the present invention use titanium dioxide nanoparticles having a particular aspect ratio, and, due to the inclusion of the titanium dioxide nanoparticles having the particular aspect ratio, a dye adsorption amount is increased, and thus generation efficiency of photoelectrons is increased and efficiency of a formed dye sensitized solar cell may be improved.

While the present invention has been described in connection with certain exemplary embodiments, it is to be understood that the invention is not limited to the disclosed embodiments, but, on the contrary, is intended to cover various modifications and equivalent arrangements included within the scope of the appended claims, and equivalents thereof.

**Claims**

1.    A dye sensitized solar cell comprising:

a first electrode;
a photoelectrode on a surface of the first electrode, the photoelectrode comprising titanium dioxide nanoparticles;
a second electrode facing the first electrode; and
an electrolyte between the first electrode and the second electrode,
wherein an aspect ratio of the titanium dioxide nanoparticles is from about 3 to about 5.

2.    The dye sensitized solar cell according to claim 1, wherein the aspect ratio of the titanium dioxide nanoparticles is from about 3.5 to about 4.5.

3. The dye sensitized solar cell according to claim 1 or 2, wherein a specific surface area of the titanium dioxide nanoparticles is 80 $m^2$/g or greater.

4. The dye sensitized solar cell according to of claim 3, wherein the specific surface area of the titanium dioxide nanoparticles is from about 81 to about 90 $m^2$/g.

5. The dye sensitized solar cell according to any one of claims 1 to 4, wherein a pore volume of the titanium dioxide nanoparticles is 0.30 $cm^3$/g or greater.

6. The dye sensitized solar cell according to claim 5, wherein the pore volume of the titanium dioxide nanoparticles is from about 0.30 to about 0.33 $cm^3$/g.

7. The dye sensitized solar cell according to any one of claims 1 to 6, wherein a pore size of the titanium dioxide nanoparticles is 14 nm or greater.

8. The dye sensitized solar cell according to claim 7, wherein the pore size of the titanium dioxide nanoparticles is from about 14 to about 16 nm.

9. The dye sensitized solar cell according to any one of claims 1 to 8, wherein an average diameter of the titanium dioxide nanoparticles is from about 10 to about 90 nm.

10. The dye sensitized solar cell according to claim 9, wherein the average diameter of the titanium dioxide nanoparticles is from about 15 to about 90 nm.

11. The dye sensitized solar cell according to claim 10, wherein the average diameter of the titanium dioxide nanoparticles is about 15 to about 25 nm.

12. The dye sensitized solar cell according to any one of claims 1 to 11, wherein the photoelectrode further comprises a dye including at least one selected from the group consisting of aluminum (Al), platinum (Pt), palladium (Pd), europium (Eu), lead (Pb), iridium (Ir), and ruthenium (Ru).

# FIG. 1

# FIG. 2A

# FIG. 2B

Europäisches
Patentamt
European
Patent Office
Office européen
des brevets

## EUROPEAN SEARCH REPORT

Application Number

EP 12 19 3976

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/083737 A1 (NISHINO HITOSHI [JP] ET AL) 14 April 2011 (2011-04-14) | 1-4,7-12 | INV. H01G9/20 |
| Y | * paragraphs [0023] - [0039], [0144] * | 5,6 | |
| X | US 2011/079276 A1 (NISHINO HITOSHI [JP] ET AL) 7 April 2011 (2011-04-07) | 1-4,7-12 | |
| Y | * paragraphs [0178] - [0187], [0018] - [0044] * | 5,6 | |
| X | US 2009/056808 A1 (JO SEONG-MU [KR] ET AL) 5 March 2009 (2009-03-05) * paragraphs [0051] - [0058] * | 1-4,9-12 | |
| X | JP 2010 208941 A (OSAKA GAS CO LTD) 24 September 2010 (2010-09-24) | 1-4,7-12 | |
| Y | * paragraphs [0032] - [0041] * | 5,6 | |
| Y | US 6 580 026 B1 (KOYANAGI TSUGUO [JP] ET AL) 17 June 2003 (2003-06-17) * column 8, lines 27-42 * | 5,6 | |

TECHNICAL FIELDS
SEARCHED (IPC)

H01G

The present search report has been drawn up for all claims

| Place of search | Date of completion of the search | Examiner |
|---|---|---|
| The Hague | 11 February 2013 | Wolfbauer, Georg |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                      

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 12 19 3976

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2013

| Patent document cited in search report | | Publication date | Patent family member(s) | | Publication date |
|---|---|---|---|---|---|
| US 2011083737 | A1 | 14-04-2011 | CN 102066243 A | | 18-05-2011 |
| | | | EP 2292558 A1 | | 09-03-2011 |
| | | | KR 20110025693 A | | 10-03-2011 |
| | | | US 2011083737 A1 | | 14-04-2011 |
| | | | WO 2009154273 A1 | | 23-12-2009 |
| US 2011079276 | A1 | 07-04-2011 | CN 102066260 A | | 18-05-2011 |
| | | | EP 2292560 A1 | | 09-03-2011 |
| | | | KR 20110022684 A | | 07-03-2011 |
| | | | US 2011079276 A1 | | 07-04-2011 |
| | | | WO 2009154274 A1 | | 23-12-2009 |
| US 2009056808 | A1 | 05-03-2009 | CN 101399122 A | | 01-04-2009 |
| | | | EP 2031613 A2 | | 04-03-2009 |
| | | | JP 2009059698 A | | 19-03-2009 |
| | | | KR 20090022181 A | | 04-03-2009 |
| | | | US 2009056808 A1 | | 05-03-2009 |
| JP 2010208941 | A | 24-09-2010 | JP 4633179 B2 | | 23-02-2011 |
| | | | JP 2010024132 A | | 04-02-2010 |
| | | | JP 2010208941 A | | 24-09-2010 |
| US 6580026 | B1 | 17-06-2003 | AU 774443 B2 | | 24-06-2004 |
| | | | AU 5571000 A | | 22-01-2001 |
| | | | EP 1119068 A1 | | 25-07-2001 |
| | | | US 6580026 B1 | | 17-06-2003 |
| | | | US 2003201010 A1 | | 30-10-2003 |
| | | | WO 0103232 A1 | | 11-01-2001 |

EPO FORM P0459

For more details about this annex : see Official Journal of the European Patent Office, No. 12/82